# EUROPÄISCHE PATENTSCHRIFT

(11) **EP 2 064 755 B1**
(45) Veröffentlichungstag und Bekanntmachung des Hinweises auf die Patenterteilung: **03.12.2014**
(21) Anmeldenummer: 07817706.0
(22) Anmeldetag: 19.10.2007
(51) Int. Cl.: H01L 41/107

(54) **PIEZOTRANSFORMATOR**
PIEZOELECTRIC TRANSFORMER
PIÉZOTRANSFORMATEUR

(30) Priorität: 23.10.2006 DE 102006049873
(43) Veröffentlichungstag der Anmeldung: 03.06.2009
(73) Patentinhaber: Epcos AG, 81669 München (DE)
(72) Erfinder: HOFFMANN, Christian, 8530 Deutschlandsberg (AT); KARTASHEV, Igor, 8530 Deutschlandsberg (AT)
(74) Vertreter: Epping - Hermann - Fischer
(86) Internationale Anmeldenummer: PCT/DE2007/001872
(87) Internationale Veröffentlichungsnummer: WO 2008/049395

(56) Entgegenhaltungen:
- EP-A- 0 714 141
- JP-A- 7 176 804
- JP-A- 2000 077 738
- US-A1- 2004 232 806

## Beschreibung

Ein Piezotransformator ist in der Druckschrift JP 2005-005683 A beschrieben.

In der Druckschrift JP 2000-077738 A ist ein Piezotransformator dargestellt, bei dem Elektroden in unterschiedlichen Funktionsteilen eines piezoelektrischen Körpers angeordnet sind, wobei die in einem ersten Funktionsteil enthaltenen Elektroden enger zueinander beabstandet sind als die in dem zweiten Funktionsteil vorgesehenen Elektroden.

Piezotransformatoren mit anderen Bauformen des Körpers sind in JP 07-176804 A und EP 0714141 A dargestellt.

Eine zu lösende Aufgabe besteht darin, einen Piezotransformator anzugeben, der eine hohe Durchschlagfestigkeit aufweist.

Die Aufgabe wird durch den im Patentanspruch 1 angegebenen Piezotransformator gelöst.

Gemäß einer Ausführungsform umfasst der Piezotransformator einen Körper, der zwei Funktionsteile umfasst, wobei jeder Funktionsteil Elektroden aufweist, die parallel zu einander gegenüberliegenden Hauptflächen des Körpers ausgerichtet sind. Der Abstand zwischen den endständigen Elektroden des zweiten Funktionsteils ist größer als der Abstand zwischen den endständigen Elektroden des ersten Funktionsteils, jeweils gemessen in Richtung senkrecht zu den Hauptflächen. Die endständigen Elektroden des ersten Funktionsteils sind im Körper angeordnet und die endständigen Elektroden des zweiten Funktionsteils sind auf den einander gegenüberliegenden Hauptflächen des Körpers angeordnet. Der Körper weist zwei erste Seitenflächen auf, die parallel zueinander ausgerichtet sind, und zwei zweite Seitenflächen, die parallel zueinander ausgerichtet sind und eine Breite des Körpers definieren. Die Funktionsteile sind in Breitenrichtung nebeneinander angeordnet. Erste Elektroden des ersten Funktionsteils sind miteinander mittels einer ersten Kontaktfläche des ersten Funktionsteils leitend verbunden. Zweite Elektroden des ersten Funktionsteils sind miteinander mittels einer zweiten Kontaktfläche des ersten Funktionsteils leitend verbunden. Eine erste Elektrode des zweiten Funktionsteils ist mit einer ersten Kontaktfläche des zweiten Funktionsteils leitend verbunden. Eine zweite Elektrode des zweiten Funktionsteils ist mit einer zweiten Kontaktfläche des zweiten Funktionsteils leitend verbunden. Die erste und zweite Kontaktfläche des ersten Funktionsteils sind an unterschiedlichen, einander gegenüberliegenden der ersten Seitenflächen angeordnet. Die erste und zweite Kontaktfläche des zweiten Funktionsteils sind an den unterschiedlichen, einander gegenüberliegenden der ersten Seitenflächen angeordnet. Die jeweiligen ersten und zweiten Kontaktflächen des ersten Funktionsteils erstrecken sich ausgehend von einer der zweiten Seitenflächen bezüglich ihrer jeweiligen Breite in Richtung zu einer anderen der zweiten Seitenflächen. Die jeweiligen ersten und zweiten Kontaktflächen des zweiten Funktionsteils erstrecken sich ausgehend von der anderen der zweiten Seitenflächen bezüglich ihrer jeweiligen Breite in Richtung zu der einen der zweiten Seitenflächen, wobei die eine der zweiten Seitenflächen und die andere der zweiten Seitenflächen zueinander gegenüberliegend angeordnet sind. Eine Breite der jeweiligen ersten und zweiten Kontaktflächen des ersten und zweiten Funktionsteils ist kleiner als eine Breite der jeweiligen ersten und zweiten Elektroden des ersten und zweiten Funktionsteils, mit der sich die Elektroden zwischen den zweiten Seitenflächen erstrecken. Die Elektroden beider Funktionsteile weisen zur Breitenanpassung an die jeweiligen Kontaktflächen in einem jeweiligen Randbereich der Elektroden jeweils eine Verjüngung mit abgerundeten Eckbereichen der Elektroden auf.

Der erste Funktionsteil bildet beispielsweise einen Eingangsteil und der zweite Funktionsteil einen Ausgangsteil des Transformators.

Im Folgenden werden vorteilhafte Ausführungsbeispiele des Piezotransformators erläutert.

In dem ersten Funktionsteil können die ersten und zweiten Elektroden abwechselnd angeordnet sein. Die endständigen Elektroden des ersten Funktionsteils, d. h. Eingangsteils, sind im Körper angeordnet, wobei die endständigen Elektroden des zweiten Funktionsteils, d. h. Ausgangsteils, vorzugsweise auf einander gegenüberliegenden Hauptflächen des Körpers angeordnet sind.

Die endständigen Elektroden des zweiten Funktionsteils sind in einer vorteilhaften Variante mittels einer elektrisch isolierenden Abdeckschicht überdeckt. Die Abdeckschicht enthält z. B. eine glashaltige Passivierungsschicht, SiO₂ oder Lack.

Durch das Einbetten der Elektroden des ersten Funktionsteils im Körperinneren gelingt es, die für einen elektrischen Überschlag ausschlaggebende Kriechstrecke zwischen den Funktionsteilen zu vergrößern und dadurch die Durchschlagsfestigkeit des Piezotransformators zu erhöhen. Durch das Anordnen der Elektroden des zweiten Funktionsteils auf der Oberfläche des Körpers gelingt es, einen besonders großen Abstand zwischen diesen Elektroden zu erzielen. Somit kann im Piezotransformator ein besonders hohes Transformationsverhältnis erzielt werden.

Durch das Anordnen der Elektroden des zweiten Funktionsteils auf der Oberfläche des Körpers kann auch das für die Wandlung der elektromechanischen Energie relevante aktive Volumen des zweiten Funktionsteils vergrößert werden. Somit kann im Piezotransformator ein besonders hoher Wirkungsgrad erzielt werden.

Der Ausgangsteil stellt vorzugsweise einen Hochspannungsteil des Transformators dar. Dies bedeutet, dass die Ausgangsspannung größer als die Eingangsspannung gewählt ist. Der Ausgangsteil kann aber auch durch den Eingangsteil ausgetauscht werden, und umgekehrt.

Der Eingangsteil und der Ausgangsteil sind mechanisch miteinander gekoppelt. Sie sind durch einen Isolierbereich des Körpers vorzugsweise elektrisch voneinander isoliert. Ein elektrisches Eingangssignal wird im Eingangsteil des piezoelektrischen Transformators in mechanische Schwingungen des Grundkörpers des Transformators umgewandelt. Aufgrund der mechanischen Kopplung des Eingangsteils und des Ausgangsteils sind beide Teile von der mechanischen Schwingung betroffen. Die Umwandlung der elektrischen Energie in mechanische Energie erfolgt aufgrund des inversen piezoelektrischen Effekts. Im Ausgangsteil werden die mechanischen Schwingungen aufgrund des direkten piezoelektrischen Effekts zurück in ein elektrisches Signal verwandelt.

Die Breite des Körpers ist vorzugsweise kleiner als seine Länge. Die Funktionsteile sind entlang der Breitenrichtung nebeneinander angeordnet. Im Körper werden Schwingungen in Breitenrichtung, d. h. in einer Lateralebene senkrecht zur Längsrichtung des Körpers, angeregt. In diesem Fall wird die Schwingungsfrequenz durch die Breite, also die kleinere laterale Größe des Körpers bestimmt. Das Verhältnis der Länge zur Breite beträgt vorzugsweise mindestens 1,2. Die Breite des Körpers beträgt vorzugsweise weniger als 5 mm. Dadurch kann eine relativ hohe Betriebsfrequenz, z. B. > 200 kHz, erzielt werden.

Der Körper ist vorzugsweise in Form einer Platte ausgebildet. Dies bedeutet, dass die Dicke des Körpers nicht größer ist als die Hälfte seiner Breite. Die Dicke des Körpers beträgt beispielsweise nicht mehr als 2 mm.

Der Körper ist vorzugsweise in Form einer rechteckigen Platte ausgebildet. Die Elektroden sind parallel zur Längsachse des Körpers ausgerichtet.

Der Körper umfasst mehrere Piezoschichten, zwischen denen Innenelektroden angeordnet sind. Die Piezoschichten enthalten vorzugsweise ein Keramikmaterial, z. B. Blei-Zirkonat-Titanat. Jede Elektrodenebene, die zwischen zwei Piezoschichten angeordnet ist, umfasst eine Elektrode des Eingangsteils und/oder des Ausgangsteils. Eine auf der unteren Hauptfläche des Körpers angeordnete Elektrodenebene umfasst eine erste endständige Elektrode des zweiten Funktionsteils. Eine auf der oberen Hauptfläche des Körpers angeordnete Elektrodenebene umfasst eine zweite endständige Elektrode des zweiten Funktionsteils. Die Hauptflächen des Körpers im Bereich des ersten Funktionsteils sind frei von den Elektroden.

Die Kontaktflächen sind senkrecht zur Längsachse des Körpers ausgerichtet.

Die zweiten Seitenflächen des Körpers sind vorzugsweise frei von den Kontaktflächen.

Die ersten und zweiten Elektroden des jeweiligen Funktionsteils sind in Längsrichtung vorzugsweise in einen ersten Bereich und einen zweiten Bereich, d. h. einen Randbereich, aufgeteilt, wobei der zweite Bereich an mindestens einer Stelle schmaler ausgebildet ist als der erste Bereich.

Der jeweilige Randbereich weist nach außen hin vorzugsweise die Verjüngung auf. Der Randbereich kann alternativ durch eine Stufe gebildet sein. Indem die Eckbereiche der Elektroden abgerundet sind, gelingt es, hohe Feldstärken an diesen Stellen zu vermeiden und die Durchschlagfestigkeit zwischen den Funktionsteilen des Piezotransformators zu erhöhen.

Im Folgenden wird der angegebene Piezotransformator anhand schematischer und nicht maßstabsgetreuer Figuren erläutert. Es zeigen:
Figur 1A im Querschnitt einen Piezotransformator, dessen Eingangsteil eine Vielzahl von Elektroden der jeweiligen Polarität aufweist;
Figur 1B den Piezotransformator gemäß der Figur 1A im Längsschnitt durch den Eingangsteil;
Figur 1C den Piezotransformator gemäß der Figur 1A im Längsschnitt durch den Ausgangsteil;
Figur 1D eine Ansicht der hinteren Stirnfläche durch den Körper des Transformators;
Figur 1E eine Ansicht der vorderen Stirnfläche des Körpers;
Figuren 1F, 1G die Draufsicht auf jeweils eine Elektrodenebene des Piezotransformators;
Figur 2A im Querschnitt einen Piezotransformator, bei dem der Ausgangsteil innen liegende Elektroden aufweist;
Figur 2B den Piezotransformator gemäß der Figur 1A im Längsschnitt durch den Ausgangsteil;
Figur 3A im Querschnitt einen Piezotransformator, bei dem der Ausgangsteil Dummy-Elektroden aufweist;
Figur 3B den Piezotransformator gemäß der Figur 3A im Längsschnitt durch den Eingangsteil;
Figur 3C den Piezotransformator gemäß der Figur 3A im Längsschnitt durch den Ausgangsteil;
Figur 4A einen Piezotransformator, bei dem der Eingangsteil nur zwei Elektroden aufweist;
Figur 4B den Piezotransformator gemäß der Figur 4A im Längsschnitt durch den Eingangsteil.

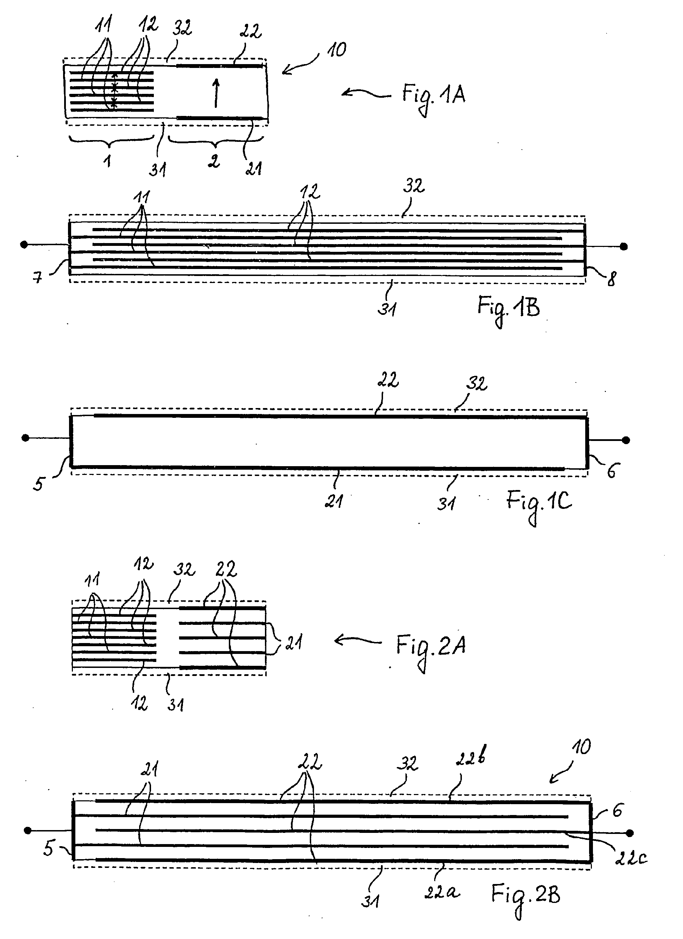

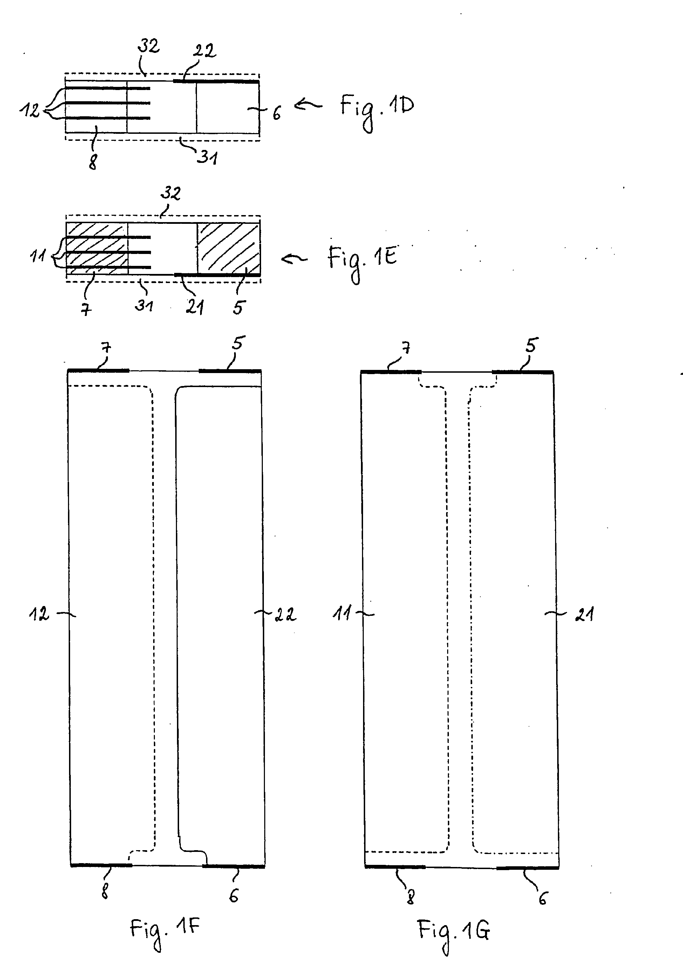

Figuren 1A bis 1G zeigen verschiedene Ansichten eines Piezotransformators mit einem Körper 10, der einen Eingangsteil 1 und einen Ausgangsteil 2 umfasst. Der Körper 10 weist zwei Hauptflächen, zwei erste und zwei zweite Seitenflächen auf. Die ersten Seitenflächen oder Stirnseiten des Körpers sind kleiner als die zweiten Seitenflächen. Der Eingangsteil 1 ist - in Breitenrichtung gesehen - neben dem Ausgangsteil 2 angeordnet. Die Schwingungen des Körpers werden mit einem elektromechanischen Kopplungskoeffizienten k₃₁ entlang der Breitenrichtung angeregt.

Der Körper 10 umfasst übereinander angeordnete Piezoschichten. Die Polarisationsrichtung der Piezoschichten ist in der Figur 1A mit Pfeilen angedeutet. Die Polarisationsachse der Piezoschichten ist senkrecht zu den Elektroden 11, 12, 21, 22 ausgerichtet.

Der Körper weist innen liegende, zwischen den Piezoschichten angeordnete Elektrodenebenen auf, in denen die ersten Innenelektroden 11 und die zweiten Innenelektroden 12 des Eingangsteils 1 ausgebildet sind. Außerdem ist jeweils eine Elektrodenebene auf der Oberseite und Unterseite des Körpers vorgesehen, in der eine außen liegende (endständige) Elektrode 21 bzw. 22 des Ausgangsteils 2 ausgebildet ist.

Der Eingangsteil 1 umfasst abwechselnd angeordnete erste und zweite Innenelektroden 11, 12 und der Ausgangsteil 2 eine außen liegende Elektrode 21 sowie eine außen liegende Elektrode 22. Zwischen den Elektroden 21, 22 ist ein Stapel von übereinander gelegten Piezoschichten, aber keine Innenelektroden angeordnet.

Die endständige Piezoschicht des Körpers 10, auf deren freien Oberfläche die Elektrode 21, 22 des Ausgangsteils 2 angeordnet ist, überdeckt die endständige Elektrode 11, 12 des Eingangsteils.

Die Hauptflächen des Körpers oder zumindest deren Bereiche mit den außen liegenden Elektroden 21, 22 sind jeweils durch eine elektrisch isolierende Abdeckschicht 31 bzw. 32 überdeckt. Die isolierende Abdeckschicht, die auch als eine Passivierungsschicht bezeichnet wird, kann ein organisches Material enthalten. Die isolierende Abdeckschicht kann auch ein anorganisches, in einer Variante glas- oder keramikhaltiges Material enthalten.

In einer weiteren Variante kann auf die Abdeckschichten 31, 32 verzichtet werden.

In der Figur 1A ist zu sehen, dass die nach außen gewandten Längskanten der Innenelektroden 11, 12 sowie der außen liegenden Elektroden 21, 22 von der Seitenfläche des Körpers zurückgezogen sind.

Die ersten Innenelektroden 11 des Eingangsteils 1 sind miteinander mittels einer ersten Kontaktfläche 7 leitend verbunden. Die zweiten Elektroden 12 des Eingangsteils 1 sind miteinander mittels einer zweiten Kontaktfläche 8 leitend verbunden. Die erste Elektrode 21 des Ausgangsteils 2 ist mit einer ersten Kontaktfläche 5 leitend verbunden. Die zweite Elektrode 22 des Ausgangsteils 2 ist mit einer zweiten Kontaktfläche 6 leitend verbunden.

Die Kontaktflächen 7, 8 des Eingangsteils 1 sind an unterschiedlichen, einander gegenüber liegenden ersten Seitenflächen des Körpers 10 angeordnet. Die Kontaktflächen 5, 6 des Ausgangsteils 2 sind an unterschiedlichen, einander gegenüber liegenden ersten Seitenflächen des Körpers 10 angeordnet. Die ersten Kontaktflächen 5, 7 der beiden Funktionsteile 1, 2 sind nebeneinander auf einer ersten Seitenfläche des Körpers 10 angeordnet. Die zweiten Kontaktflächen 6, 8 der beiden Funktionsteile 1, 2 sind nebeneinander auf einer zweiten Seitenfläche des Körpers 10 angeordnet. An der jeweiligen Kontaktfläche 5, 6, 7, 8 ist ein Anschlussdraht 9 befestigt ist. In den Figuren 2A und 2B sind verschiedene Ansichten eines weiteren Piezotransformators vorgestellt.

Der Ausgangsteil 2 umfasst in diesem Fall mehrere abwechselnd angeordnete erste Elektroden 21 und zweite Elektroden 22. Die Elektroden des Ausgangsteils umfassen sowohl innen liegende Elektroden 21, 22c als auch außen liegende Elektroden 22a, 22b. Die außen liegenden Elektroden können wie in der Variante gemäß der Figur 2B auf gleichem Potential liegende, beispielsweise zweite Elektroden oder alternativ erste Elektroden des Ausgangsteils sein. Die außen liegenden Elektroden können wie in der Variante gemäß der Figur 1C voneinander unterschiedlichen elektrischen Potentialen zugeordnet sein.

Der Abstand zwischen den aufeinander folgenden Elektroden ist im Ausgangsteil 2 größer als im Eingangsteil 1. Dies bedeutet, dass im Ausgangsteil mindestens zwei Piezoschichten direkt aufeinander folgen. Um den Höhenunterschied der durch den Eingangsteil und den Ausgangsteil gebildeten Stapel zu vermeiden, der zu unerwünschten mechanischen Spannungen im Körper führen könnte, sind im Ausgangsteil vorzugsweise Dummy-Elektroden vorgesehen.

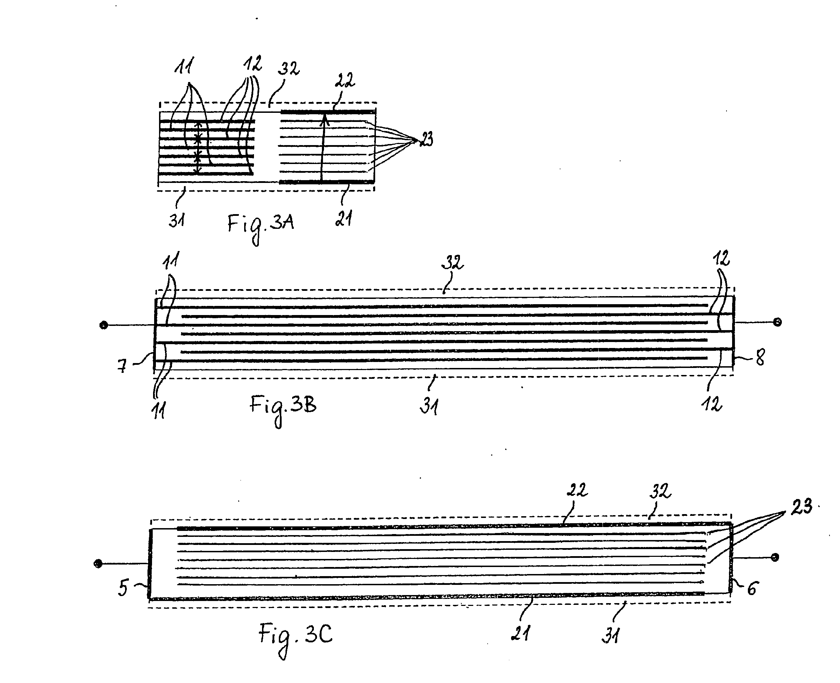

Dieses Ausführungsbeispiel ist in den Figuren 3A, 3B und 3C erläutert. Hier sind im Körper 10 im Bereich des Ausgangsteils 2 Dummy-Elektroden vorgesehen. Die Dummy-Elektroden stellen floatende Metallflächen dar, d. h. Metallflächen, die mit keiner der Kontaktflächen 5, 6, 7, 8 des Transformators leitend verbunden sind. Vorzugsweise ist in einer jeden innen liegenden Elektrodenebene eine Dummy-Elektrode vorgesehen, die neben der Innenelektrode 11 oder 12 des Eingangsteils angeordnet ist.

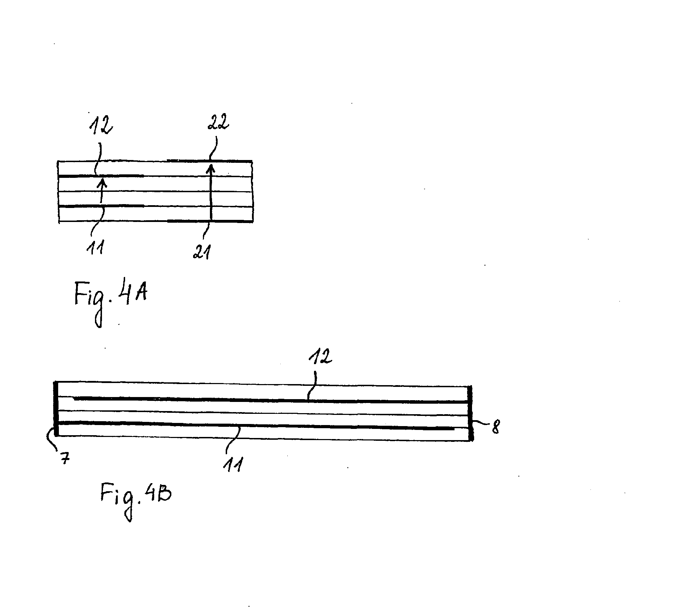

In den Figuren 4A, 4B ist ein weiteres Ausführungsbeispiel gezeigt. In diesem Fall ist im Eingangsteil 1, wie auch im Ausgangsteil 2, nur eine erste Elektrode 11 und eine zweite Elektrode 12 vorgesehen. Allerdings sind die Elektroden 11, 12 des Eingangsteils 1 im Körper 10 eingebettet, wohingegen die Elektroden 21, 22 des Ausgangsteils 2 an der Oberfläche des Körpers 10 liegen.

Die in Breitenrichtung des Körpers gemessene Breite der jeweiligen Kontaktfläche ist kleiner als die in dieser Richtung gemessene Breite der an sie angeschlossenen Elektroden. Die Elektroden der Funktionsteile 1, 2 weisen zur Breitenanpassung in ihrem Randbereich eine Abstufung auf (Fig. 1F, 1G). Die Eckbereiche der Elektroden sind dabei abgerundet.

Jede erste Elektrode 11, 21 weist einen ersten Bereich, d. h. Überlappungsbereich, auf, der mit einem ersten Bereich der darunter oder darüber angeordneten zweiten Elektrode 12, 22 überlappt. Die jeweilige Elektrode 11, 12, 21, 22 weist außerdem einen zweiten Bereich, d. h. Verbindungsbereich, auf, der den ersten Bereich mit der jeweiligen Kontaktfläche 7, 8, 5 bzw. 6 verbindet. Der zweite Bereich ist schmaler als der erste Bereich.

Der Abstand zwischen den nebeneinander angeordneten ersten Kontaktflächen 5, 7 bzw. zweiten Kontaktflächen 6, 8 ist größer als der Abstand zwischen dem Eingangsteil 1 und dem Ausgangsteil 2. Die Wahrscheinlichkeit eines elektrischen Überschlags zwischen zwei mit unterschiedlichen Potentialen beaufschlagten Metallstrukturen ist entlang der Oberfläche des Körpers größer als im Körperinneren. Daher ist ein großer Abstand zwischen den nebeneinander liegenden Kontaktflächen 5, 6 (oder 7, 8) im Hinblick auf die Erhöhung der Durchschlagfestigkeit zwischen den Funktionsteilen des Transformators besonders vorteilhaft.

Die Ausgestaltung des angegebenen Piezotransformators, insbesondere die Form und Anzahl von Transformatorelementen, ist auf die in den Figuren gezeigten Ausführungsbeispiele nicht beschränkt.

### Bezugszeichenliste

- 1: Eingangsteil
- 10: Körper
- 11: erste Elektroden des Eingangsteils
- 12: zweite Elektroden des Eingangsteils
- 2: Ausgangsteil
- 21: erste Elektroden des Ausgangsteils
- 22: zweite Elektroden des Ausgangsteils
- 22a, 22b: endständige Elektroden des Ausgangsteils
- 22c: innen liegende Elektrode des Ausgangsteils
- 31, 32: Passivierungsschicht
- 5: erste Kontaktfläche des Ausgangsteils
- 6: zweite Kontaktfläche des Ausgangsteils
- 7: erste Kontaktfläche des Eingangsteils
- 8: zweite Kontaktfläche des Eingangsteils
- 9: Anschlussdraht

## Patentansprüche

1. Piezotransformator
- mit einem Körper (10), der zwei Funktionsteile (1, 2) umfasst,
- wobei jeder Funktionsteil (1, 2) Elektroden (11, 21; 12, 22) aufweist, die parallel zu einander gegenüberliegenden Hauptflächen des Körpers (10) ausgerichtet sind,
- wobei der Abstand zwischen den endständigen Elektroden des zweiten Funktionsteils (2) größer ist als der Abstand zwischen den endständigen Elektroden des ersten Funktionsteils (1), jeweils gemessen in Richtung senkrecht zu den Hauptflächen,
- wobei die endständigen Elektroden (11, 12) des ersten Funktionsteils (1) im Körper (10) angeordnet sind,
- wobei die endständigen Elektroden (21, 22) des zweiten Funktionsteils (2) auf den einander gegenüberliegenden Hauptflächen des Körpers (10) angeordnet sind,
- wobei der Körper (10) zwei erste Seitenflächen aufweist,
die parallel zueinander ausgerichtet sind,
- wobei der Körper (10) zwei zweite Seitenflächen aufweist, die parallel zueinander ausgerichtet sind und eine Breite des Körpers definieren,
- wobei die Funktionsteile (1, 2) in Breitenrichtung nebeneinander angeordnet sind,
- wobei erste Elektroden (11) des ersten Funktionsteils (1) miteinander mittels einer ersten Kontaktfläche (7) des ersten Funktionsteils leitend verbunden sind,
- wobei zweite Elektroden (12) des ersten Funktionsteils (1) miteinander mittels einer zweiten Kontaktfläche (8) des ersten Funktionsteils leitend verbunden sind,
- wobei eine erste Elektrode (21) des zweiten Funktionsteils (2) mit einer ersten Kontaktfläche (5) des zweiten Funktionsteils leitend verbunden ist,
- wobei eine zweite Elektrode (22) des zweiten Funktionsteils (2) mit einer zweiten Kontaktfläche (6) des zweiten Funktionsteils leitend verbunden ist,
- wobei die erste und zweite Kontaktfläche (7, 8) des ersten Funktionsteils (1) an unterschiedlichen, einander gegenüberliegenden der ersten Seitenflächen angeordnet sind,
- wobei die erste und zweite Kontaktfläche (5, 6) des zweiten Funktionsteils (2) an den unterschiedlichen, einander gegenüberliegenden der ersten Seitenflächen angeordnet sind,
- wobei sich die jeweiligen ersten und zweiten Kontaktflächen (7, 8) des ersten Funktionsteils (1) ausgehend von einer der zweiten Seitenflächen bezüglich ihrer jeweiligen Breite in Richtung zu einer anderen der zweiten Seitenflächen erstrecken und wobei sich die jeweiligen ersten und zweiten Kontaktflächen (5, 6) des zweiten Funktionsteils (2) ausgehend von der anderen der zweiten Seitenflächen bezüglich ihrer jeweiligen Breite in Richtung zu der einen der zweiten Seitenflächen erstrecken, wobei die eine der zweiten Seitenflächen und die andere der zweiten Seitenflächen zueinander gegenüberliegend angeordnet sind,
**dadurch gekennzeichnet, dass** eine Breite der jeweiligen ersten und zweiten Kontaktflächen (5, 6, 7, 8) des ersten und zweiten Funktionsteils (1, 2) kleiner ist als eine Breite der jeweiligen ersten und zweiten Elektroden (11, 12, 21, 22) des ersten und zweiten Funktionsteils (1, 2), mit der sich die Elektroden (11, 12, 21, 22) zwischen den zweiten Seitenflächen erstrecken und die Elektroden (11, 12, 21, 22) beider Funktionsteile (1, 2) zur Breitenanpassung an die jeweiligen Kontaktflächen (5, 6, 7, 8) in einem jeweiligen Randbereich der Elektroden (11, 12, 21, 22) jeweils eine Verjüngung mit abgerundeten Eckbereichen der Elektroden (11, 12, 21, 22) aufweisen.

2. Piezotransformator nach Anspruch 1,
- wobei die Breite des Körpers (10) kleiner ist als seine Länge.

3. Piezotransformator nach einem der Ansprüche 1 oder 2,
- wobei der erste Funktionsteile (1) abwechselnd angeordnete erste und zweite Elektroden (11, 12) aufweist.

4. Piezotransformator nach einem der Ansprüche 1 bis 3,
- wobei der zweite Funktionsteil (2) mindestens eine innen liegende Elektrode (22c) aufweist.

5. Piezotransformator nach einem der Ansprüche 1 bis 4,
- wobei der Körper (10) in Form einer Platte ausgebildet ist.

6. Piezotransformator nach einem der Ansprüche 1 bis 5,
- wobei zumindest endständige Elektroden (22a, 22b) des zweiten Funktionsteils (2) mittels einer elektrisch isolierenden Abdeckschicht (31, 32) überdeckt sind.

7. Piezotransformator nach einem der Ansprüche 1 bis 6,
- wobei der erste Funktionsteil (1) einen Eingangsteil und der zweite Funktionsteil (2) einen Ausgangsteil des Transformators bildet.

## Claims

1. Piezoelectric transformer
- comprising a body (10), which comprises two functional parts (1, 2),
- wherein each functional part (1, 2) has electrodes (11, 21; 12, 22), which are oriented parallel to mutually opposite main faces of the body (10),
- wherein the distance between the end electrodes of the second functional part (2) is greater than the distance between the end electrodes of the first functional part (1), in each case measured in a direction perpendicular to the main faces,
- wherein the end electrodes (11, 12) of the first functional part (1) are arranged in the body (10),
- wherein the end electrodes (21, 22) of the second functional part (2) are arranged on the mutually opposite main faces of the body (10),
- wherein the body (10) has two first side faces, which are oriented parallel to one another,
- wherein the body (10) has two second side faces, which are oriented parallel to one another and define a width of the body,
- wherein the functional parts (1, 2) are arranged next to one another in width direction,
- wherein first electrodes (11) of the first functional part (1) are conductively connected to one another by means of a first contact face (7) of the first functional part,
- wherein second electrodes (12) of the first functional part (1) are conductively connected to one another by means of a second contact face (8) of the first functional part,
- wherein a first electrode (21) of the second functional part (2) is conductively connected to a first contact face (5) of the second functional part,
- wherein a second electrode (22) of the second functional part (2) is conductively connected to a second contact face (6) of the second functional part,
- wherein the first and second contact faces (7, 8) of the first functional part (1) are arranged on different, mutually opposite side faces of the first side faces,
- wherein the first and second contact faces (5, 6) of the second functional part (2) are arranged on different, mutually opposite side faces of the first side faces,
- wherein the respective first and second contact faces (7, 8) of the first functional part (1) extend, starting from one of the second side faces, in the direction towards another of the second side faces with respect to the respective width thereof, and wherein the respective first and second contact faces (5, 6) of the second functional part (2) extend, starting from the other of the second side faces, in the direction towards one of the second side faces, with respect to the respective width thereof, wherein one of the second side faces and the other of the second side faces are arranged opposite one another, **characterized in that** a width of the respective first and second contact faces (5, 6, 7, 8) of the first and second functional parts (1, 2) is less than a width of the respective first and second electrodes (11, 12, 21, 22) of the first and second functional parts (1, 2) by which the electrodes (11, 12, 21, 22) extend between the second side faces, and the electrodes (11, 12, 21, 22) of both functional parts (1, 2) each have a tapering with rounded corner regions of the electrodes (11, 12, 21, 22) in order to match the width to the respective contact faces (5, 6, 7, 8) in a respective peripheral region of the electrodes (11, 12, 21, 22).

2. Piezoelectric transformer according to Claim 1,
- wherein the width of the body (10) is smaller than its length.

3. Piezoelectric transformer according to either of Claims 1 and 2,
- wherein the first functional part (1) has alternately arranged first and second electrodes (11, 12).

4. Piezoelectric transformer according to one of Claims 1 to 3,
- wherein the second functional part (2) has at least one inner electrode (22c).

5. Piezoelectric transformer according to one of Claims 1 to 4,
- wherein the body (10) is in the form of a plate.

6. Piezoelectric transformer according to one of Claims 1 to 5,
- wherein at least end electrodes (22a, 22b) of the second functional part (2) are covered by means of an electrically insulating cover layer (31, 32).

7. Piezoelectric transformer according to one of Claims 1 to 6,
- wherein the first functional part (1) forms an input part, and the second functional part (2) forms an output part of the transformer.

## Revendications

1. Transformateur piézoélectrique
- comprenant un corps (10) qui inclut deux parties fonctionnelles (1, 2),
- chaque partie fonctionnelle (1, 2) possédant des électrodes (11, 21 ; 12, 22) qui sont orientées parallèlement avec les surfaces principales du corps (10) opposées l'une à l'autre,
- l'écart entre les électrodes terminales de la deuxième partie fonctionnelle (2) étant supérieur à l'écart entre les électrodes terminales de la première partie fonctionnelle (1), respectivement mesurés dans la direction perpendiculaire aux surfaces principales,
- les électrodes terminales (11, 12) de la première partie fonctionnelle (1) étant disposées dans le corps (10),
- les électrodes terminales (21, 22) de la deuxième partie fonctionnelle (2) étant disposées sur les surfaces principales du corps (10) opposées l'une à l'autre,
- le corps (10) présentant deux premières surfaces latérales qui sont orientées parallèlement l'une à l'autre,
- le corps (10) présentant deux deuxièmes surfaces latérales qui sont orientées parallèlement l'une à l'autre et qui définissent une largeur du corps,
- les parties fonctionnelles (1, 2) étant disposées l'une à côté de l'autre dans le sens de la largeur,
- les premières électrodes (11) de la première partie fonctionnelle (1) étant reliées de manière conductrice entre elles à l'aide d'une première surface de contact (7) de la première partie fonctionnelle,
- les deuxièmes électrodes (12) de la première partie fonctionnelle (1) étant reliées de manière conductrice entre elles à l'aide d'une deuxième surface de contact (8) de la première partie fonctionnelle,
- une première électrode (21) de la deuxième partie fonctionnelle (2) étant reliée de manière conductrice à une première surface de contact (5) de la deuxième partie fonctionnelle,
- une deuxième électrode (22) de la deuxième partie fonctionnelle (2) étant reliée de manière conductrice à une deuxième surface de contact (6) de la deuxième partie fonctionnelle,
- la première et la deuxième surface de contact (7, 8) de la première partie fonctionnelle (1) étant disposées sur des surfaces latérales différentes opposées l'une à l'autre parmi les premières surfaces latérales,
- la première et la deuxième surface de contact (5, 6) de la deuxième partie fonctionnelle (2) étant disposées sur les surfaces latérales différentes opposées l'une à l'autre parmi les premières surfaces latérales,
- les première et deuxième surfaces de contact (7, 8) respectives de la première partie fonctionnelle (1), en partant de l'une des deuxièmes surfaces latérales, s'étendant au niveau de leur largeur respective en direction d'une autre des deuxièmes surfaces latérales et les première et deuxième surfaces de contact (5, 6) respectives de la deuxième partie fonctionnelle (2), en partant de l'autre des deuxièmes surfaces latérales, s'étendant au niveau de leur largeur respective en direction de l'une des deuxièmes surfaces latérales, l'une des deuxièmes surfaces latérales et l'autre des deuxièmes surfaces latérales étant opposées l'une à l'autre,
**caractérisé en ce qu'**une largeur des premières et deuxièmes surfaces de contact (5, 6, 7, 8) respectives de la première et de la deuxième partie fonctionnelle (1, 2) est inférieure à une largeur des premières et deuxièmes électrodes (11, 12, 21, 22) respectives de la première et de la deuxième partie fonctionnelle (1, 2) avec laquelle les électrodes (11, 12, 21, 22) s'étendent entre les deuxièmes surfaces latérales et les électrodes (11, 12, 21, 22) des deux parties fonctionnelles (1, 2) présentent respectivement, dans une zone de bord respective des électrodes (11, 12, 21, 22), un rétrécissement muni de zones de coin arrondies des électrodes (11, 12, 21, 22) pour l'adaptation en largeur aux surfaces de contact (5, 6, 7, 8) respectives.

2. Transformateur piézoélectrique selon la revendication 1, avec lequel la largeur du corps (10) est inférieure à sa longueur.

3. Transformateur piézoélectrique selon l'une des revendications 1 ou 2, avec lequel la première partie fonctionnelle (1) possède des premières et deuxièmes électrodes (11, 12) disposées en alternance.

4. Transformateur piézoélectrique selon l'une des revendications 1 à 3, avec lequel la deuxième partie fonctionnelle (2) possède au moins une électrode interne (22c).

5. Transformateur piézoélectrique selon l'une des revendications 1 à 4, avec lequel le corps (10) est réalisé sous la forme d'une plaque.

6. Transformateur piézoélectrique selon l'une des revendications 1 à 5, avec lequel au moins les électrodes terminales (22a, 22b) de la deuxième partie fonctionnelle (2) sont recouvertes au moyen d'une couche de protection (31, 32) isolante électriquement.

7. Transformateur piézoélectrique selon l'une des revendications 1 à 6, avec lequel la première partie fonctionnelle (1) forme une partie d'entrée et la deuxième partie fonctionnelle (2) une partie de sortie du transformateur.
